# EUROPÄISCHE PATENTANMELDUNG

(11) **EP 4 535 015 A1**
(43) Veröffentlichungstag der Anmeldung: **09.04.2025**
(21) Anmeldenummer: 24202092.3
(22) Anmeldetag: 24.09.2024
(51) Int. Cl.: G01R 31/26, H05B 3/00

(54) **SYSTEM UND VERFAHREN ZUR ÜBERWACHUNG EINER ELEKTRISCHEN WIDERSTANDSÄNDERUNG**

(30) Priorität: 05.10.2023 DE 102023209761
(71) Anmelder: Benecke-Kaliko AG, 30419 Hannover (DE)
(72) Erfinder: Kneer, Janosch, 30419 Hannover (DE); Kegel, Isabell, 30419 Hannover (DE); Schleuniger, Juerg, 30419 Hannover (DE); Benz, Nicolai, 30419 Hannover (DE); Rösch, Simon, 30419 Hannover (DE); Nassauer, Benjamin, 30419 Hannover (DE)
(74) Vertreter: Continental Corporation

(57) **Zusammenfassung**

Die Erfindung betrifft ein System (100) zur Überwachung einer elektrischen Widerstandsänderung mit einer auf einem Substrat (1) angeordneten ersten elektrisch leitfähigen Schicht (2) und einer zweiten elektrisch leitfähigen Schicht (4) und vorzugsweise einer dritten elektrisch leitfähigen Schicht (12), wobei die erste Schicht und die zweite Schicht und vorzugsweise die dritte Schicht mehrere Einzelsegmente (8, 10, 14) aufweisen, wobei die Einzelsegmente (8) parallel geschaltet sind. Jedes Einzelsegment (10, 14) ist mit einer elektronischen Rechenvorrichtung (6) verbunden. Die elektronische Rechenvorrichtung ist ausgebildet, einen elektrischen Widerstand (Rₙₑᵤ) jedes Einzelsegments (10, 14) im Ursprungszustand zu bestimmen und die Einhaltung definierter und in der elektronischen Rechenvorrichtung hinterlegter Grenzwerte anhand einer Abweichung des aktuellen elektrischen Widerstands (Rₐₖₜᵤₑₗₗ) jedes Einzelsegments (10, 14) gegenüber dem elektrischen Widerstand (Rₙₑᵤ) jedes Einzelsegments (10, 14) im Ursprungszustand zu überprüfen.

## Beschreibung

Die Erfindung betrifft ein System zur Überwachung einer elektrischen Widerstandsänderung gemäß dem Oberbegriff des Anspruchs 1 sowie ein Verfahren zur Überwachung einer elektrischen Widerstandsänderung mit Hilfe eines erfindungsgemäßen Systems.

Beispielsweise werden im Automobilbau Innenraumoberflächen durch mehrschichtige Aufbauten erzielt. Diese Aufbauten umfassen häufig eine Schaumschicht und eine Oberschicht. Auf diese Weise können Bauteile wie Türverkleidungen, Instrumententafeln oder Armauflagen aufgebaut sein. Um solche Oberflächen zu beheizen, kommen häufig Heizdrähte zum Einsatz. Dabei erweist es sich aufgrund des verhältnismäßig großen Abstands der Heizdrähte zueinander als ausgesprochen nachteilig, dass die Oberfläche des Verbundmaterials lokal ungleichmäßig erwärmt wird, wodurch spürbare warme und kalte Regionen an der Oberfläche entstehen können.

Daher wird angestrebt, möglichst dünne und großflächig beheizbare Lagen innerhalb des mehrschichtigen Verbundmaterials nahe an der Oberfläche anzuordnen.

Aus der EP 1 924 125 B1 ist es bekannt, eine Polymerschicht auf Basis von Polyurethan oder PVC durch Zugabe von leitfähigen Additiven, zum Beispiel Nanotubes, Silber, ionischen Flüssigkeiten, Graphitpartikeln und/oder Kupferpartikeln in das pastenförmige Kunststoffmaterial vor Ausbildung der Schicht elektrisch leitfähig auszurüsten, um diese nach Ausbildung der Schicht mittels Stromdurchfluss unmittelbar elektrisch zu beheizen.

Die DE 10 2020 215 949 A1 offenbart ein Verfahren zur Herstellung einer elektrisch heizbaren Schicht aus einem pastenförmigen Kunststoffmaterial, wobei in das Kunststoffmaterial ferner ein Kontaktierungsadditiv hineindispergiert wird, wodurch die elektrisch heizbare Schicht einfacher und zuverlässiger elektrisch kontaktierbar ist. Das pastenförmige Kunststoffmaterial kann in einem Druckverfahren auf das Trägermaterial appliziert werden, wodurch zum Beispiel Strukturen in Form von Leiterbahnen zur Stromzufuhr der elektrisch heizbaren Schicht gebildet werden können.

Die elektrisch leitfähigen Strukturen weisen einen elektrischen Widerstand auf, aufgrund dessen bei Stromführung eine Verlustleistung entsteht, was in einer Erwärmung der elektrisch leitfähigen Strukturen resultiert. Durch die dauerhafte Wärmebelastung können die elektrisch leitfähigen Strukturen der Heizschicht über die Dauer thermisch altern, was sich in einer Veränderung des elektrischen Widerstands und je nach Betriebsart der Leistungsaufnahme oder der resultierenden Wärmeabgabe äußert.

Daher besteht eine Anforderung darin, die Alterung elektrisch leitfähiger Strukturen überwachen zu können. Hierzu offenbart die DE 10 2015 225 909 A1 eine Lösung zur Überwachung des Alterungszustandes eines Halbleiterbauelements, bei der der Alterungswert durch einen Vergleich zwischen der aktuellen Amplitude eines Temperatursignals im Vergleich zu einer Referenzamplitude eines Temperatursignals verglichen wird.

Eine weitere Möglichkeit besteht darin, die Alterung auf Grundlage einer Veränderung des thermischen elektrischen Widerstands durch einen Vergleich zwischen einem aktuellen thermischen Widerstand und einem thermischen Referenzwiderstand zu bestimmen.

Eine Alternative zu der direkten Überwachung des betrachteten Bauteils ist aus der DE 20 2012 002 925 U1 bekannt. Hierbei kann indirekt über eine alterungsbedingte Widerstandserhöhung einer Referenzstruktur auf die Alterung eines zu überwachenden Sicherungselements Rückschluss gezogen werden. Typischerweise werden bei einem Flächenheizelement mehrere elektrisch leitfähige Einzelsegmente zu einem elektrischen Zweipol parallel geschaltet. Bei einem Defekt einzelner elektrisch leitfähiger Segmente können diese individuell entkoppelt werden, ohne dass dies einen Gesamtausfall des Flächenheizelements nach sich ziehen würde. Nachteiliger Weise kann das Entkoppeln einzelner Segmente zu einer inhomogenen Temperaturverteilung über die Fläche des Heizelements führen, was nur bis zu einem gewissen Temperaturgradienten tolerierbar ist. Allerdings ist es technisch sehr aufwändig, jedes der zu einem elektrischen Zweipol parallel geschalteten elektrisch leitfähigen Segmente zusätzlich dazu auszulegen, einzeln mit einer elektronischen Rechenvorrichtung kontaktiert und auf eine Änderung des elektrischen Widerstands überwacht zu werden. Die zur Ermittlung des temperaturabhängigen elektrischen Widerstands erforderlichen Parameter Stromstärke, Spannung und Temperatur werden daher in aller Regel auf das zweipolige Heizelement insgesamt bezogen.

Nachteiliger Weise kann hierdurch keine Aussage über eine inhomogene Temperaturverteilung getroffen werden, da nur der Gesamtstromfluss ausgewertet wird, der aufgrund unterschiedlicher elektrischer Widerstandswerte der einzelnen Heizsegmente lokal unterschiedlich in joulesche Wärme umgesetzt werden kann. Eine ungleichmäßige Widerstandsänderung der elektrisch leitfähigen Einzelsegmente aufgrund thermischer Alterung sowie eine ggfs. individuell variierende Schichtdicke können ebenfalls zu Temperaturschwankungen über die gesamte Fläche des Heizelements führen.

Der Erfindung liegt daher die Aufgabe zugrunde, ein System bereitzustellen, welches eine Alterung elektrisch leitfähiger Strukturen über die Zeit detektieren und auf die Einhaltung geforderter Toleranzgrenzen überwachen kann. Zusätzlich oder alternativ soll die Homogenität der Einzelwiderstände im Falle mehrerer zu einem elektrischen Zweipol parallel geschalteter Einzelwiderstände auf die Einhaltung geforderter Toleranzgrenzen überwacht werden können.

Die Lösung dieser Aufgabe ergibt sich durch ein System zur Überwachung einer elektrischen Widerstandsänderung mit den Merkmalen des unabhängigen Anspruchs 1. Eine weitere Lösung ergibt sich durch ein Verfahren zur Überwachung einer elektrischen Widerstandsänderung mit Hilfe eines erfindungsgemäßen Systems gemäß Anspruch 10.

Weitere vorteilhafte Ausbildungen sind den abhängigen Ansprüchen sowie der allgemeinen Beschreibung und den Ausführungsbeispielen zu entnehmen.

Die vorliegende Anmeldung betrifft ein System zur Überwachung einer elektrischen Widerstandsänderung mit einer auf einem Substrat angeordneten ersten elektrisch leitfähigen Schicht und einer zweiten elektrisch leitfähigen Schicht und vorzugsweise einer dritten elektrisch leitfähigen Schicht, wobei die erste Schicht und die zweite Schicht und vorzugsweise die dritte Schicht mehrere Einzelsegmente aufweisen, wobei die Einzelsegmente der ersten Schicht parallel geschaltet sind, und wobei jedes Einzelsegment der zweiten Schicht und vorzugsweise dritten Schicht mit einer elektronischen Rechenvorrichtung verbunden ist. Die elektronische Rechenvorrichtung ist ausgebildet, einen elektrischen Widerstand jedes Einzelsegments im Ursprungszustand zu bestimmen und in der elektronischen Rechenvorrichtung zu hinterlegen und die Einhaltung definierter und in der elektronischen Rechenvorrichtung hinterlegter Grenzwerte anhand einer Abweichung eines aktuellen elektrischen Widerstands jedes Einzelsegments gegenüber dem elektrischen Widerstand jedes Einzelsegments im Ursprungszustand und anhand einer Abweichung des aktuellen elektrischen Widerstands jedes Einzelsegments untereinander zu überprüfen.

Mit anderen Worten ermöglicht das erfindungsgemäße System durch die Überwachung der Änderung der Widerstände gegenüber dem Ursprungszustand, Rückschluss auf eine Alterung der zweiten elektrisch leitfähigen Schicht zu ziehen. Da die zweite elektrisch leitfähige Schicht vorzugsweise aus demselben Material wie das der ersten elektrisch leitfähigen Schicht ausgebildet ist, kann ein direkter Zusammenhang zu der Alterung der ersten elektrisch leitfähigen Schicht hergestellt werden, ohne dass eine technisch sehr aufwändige Widerstandsmessung der Einzelsegmente der ersten elektrisch leitfähigen Schicht vorgenommen werden muss. Die erste elektrisch leitfähige Schicht und die zweite elektrisch leitfähige Schicht erfahren z. B. bei wiederkehrendem Wärmeeintrag parallele und proportionale Alterungseffekte. Die zweite elektrisch leitfähige Schicht bildet mit anderen Worten eine Referenzstruktur zur indirekten Überwachung der Alterung der ersten elektrisch leitfähigen Schicht.

Durch die teils individuellen und voneinander abweichenden Einzelwiderstände der elektrisch leitfähigen Einzelsegmente kann die Verlustleistung und somit die Wärmeabgabe über die Fläche der ersten elektrischen Leitfähigen Schicht inhomogenen verteilt sein. Durch den Abgleich der aktuellen elektrischen Widerstandswerte der Einzelsegmente der zweiten elektrisch leitfähigen Schicht untereinander kann darüber hinaus unabhängig von Alterungseffekten Rückschluss auf eine inhomogene Verteilung der elektrischen Widerstände der Einzelsegmente gezogen werden. Hierdurch kann bei Stromführung der ersten elektrisch leitfähigen Schicht und einer sich einstellenden und in einer Wärmeabgabe resultierenden widerstandsbedingten Verlustleitung auch Rückschluss auf eine inhomogene Temperaturverteilung über die Fläche des Substrats bzw. der ersten elektrisch leitfähigen Schicht gezogen werden.

Alternativ zu der zweiten elektrisch leitfähigen Schicht kann das Substrat mit einer dritten elektrisch leitfähigen Schicht mit mehreren Einzelsegmenten beschichtet sein, deren elektrische Widerstände analog zu der zweiten elektrisch leitfähigen Schicht gemessen werden können. Zur Messung des elektrischen Widerstands können die zweite und bzw. oder die dritte elektrisch leitfähige Schicht mit einem Anregungsstrom beaufschlagt werden, sodass der elektrische Widerstand durch einen sich einstellenden Spannungsabfall bestimmt werden kann.

Die elektrisch leitfähigen Strukturen bzw. Einzelsegmente der jeweiligen elektrisch leitfähigen Schichten können direkt auf das Substrat aus einem polymeren Material, beispielsweise einem thermoplastischem Polyolefin (TPO), vorzugsweise einem thermoplastischen Polyurethan (TPU) gedruckt werden. Hierzu kann ein pastöses Material mit elektrisch leitfähigen Additiven, zum Beispiel aus Kohlenstoff oder Silber, versetzt werden. So können elektrisch leitfähige Strukturen, z. B. in Form von Leiterbahnen, die besonders dünn, dehnfähig und biegeflexibel sind, in einem Druckverfahren erzeugt werden. Durch Trocknung, z.B. in einem Ofen, erstarrt das pastöse Material und härtet aus, wodurch eine formstabile Struktur erhalten bleibt. Auf diese Weise kann durch flächiges Bedrucken die elektrisch leitfähige Schicht erzeugt werden.

Auf besonders vorteilhafte Weise kann die erfindungsgemäße Referenzstruktur bzw. die zweite und bzw. oder die optional dritte elektrisch leitfähige Schicht außerhalb der Ebene der ersten elektrisch leitfähigen Schicht angeordnet sein, sodass die Flächenleistung der ersten elektrisch leitfähigen Schicht nicht nachteilig beeinflusst wird. Aufgrund der sehr dünnen Schichtdicke der elektrisch leitfähigen Strukturen im Bereich zwischen 5-30 µm kann ein insgesamt kompakter Schichtaufbau der elektrisch leitfähigen Schichten gewährleistet werden.

Gemäß einem weiteren Aspekt der vorliegenden Erfindung ist die erste elektrisch leitfähige Schicht elektrisch beheizbar. Die erste elektrische leitfähige Schicht kann zur Stromversorgung an eine Spannungsquelle angeschlossen werden. Die elektrisch leitfähige Schicht kann sich bei Stromführung aufgrund der durch den elektrischen Widerstand bedingten Verlustleistung erwärmen. Die Wärme der ersten elektrisch leitfähigen Schicht wirkt unmittelbar auf die direkt angrenzende zweite und optional dritte elektrisch leitfähige Schicht ein. Hierdurch erfahren die weiteren elektrisch leitfähigen Schichten dieselbe thermische Alterung der ersten elektrisch leitfähigen Schicht. Die Widerstandsänderung der als Referenzstruktur ausgebildeten zweiten und optional dritten elektrisch leitfähigen Schicht ist somit repräsentativ für die Widerstandsänderung der ersten elektrisch leitfähigen Schicht.

Zusätzlich kann die zweite elektrisch leitfähige Schicht und bzw. oder die dritte elektrisch leitfähige Schicht als Berührungssensor dienen. Wenn die erste elektrisch leitfähige Schicht eine konstante Temperatur erreicht hat und damit verbunden in eine konstante Leistungsaufnahme übergeht, kann die zweite oder dritte elektrisch leitfähige Schicht bei einer durch Berührung bedingten Kompression eine temperaturunabhängige Widerstandsänderung erfahren, welche als Sensorsignal für eine Berührungserkennung verwendet werden kann. So kann bei einer Berührungserkennung z. B. die Heizleistung der ersten elektrisch leitfähigen Schicht reduziert oder gestoppt werden.

Gemäß einem weiteren Aspekt der vorliegenden Erfindung sind die Einzelsegmente der dritten elektrisch leitfähigen Schicht im Wesentlichen quer zu den Einzelsegmenten der zweiten elektrisch leitfähigen Schicht verlaufend angeordnet.

Mit anderen Worten sind die Einzelsegmente der dritten elektrisch leitfähigen Schicht wenigstens einem, vorzugsweise einer Mehrzahl Einzelsegmente der zweiten elektrisch leitfähigen Schicht zugeordnet bzw. stehen mit diesen in Kontakt. So kann durch die Einzelsegmente der zweiten elektrisch leitfähige Schicht eine inhomogene Verteilung der Widerstände bzw. eines daraus bestimmbaren Temperaturgradienten in einer ersten Richtung und durch die Einzelsegmente der dritten elektrisch leitfähige Schicht eine inhomogene Verteilung der Widerstände bzw. eines daraus bestimmbaren Temperaturgradienten in eine zweite Richtung, welche quer zur ersten Richtung verläuft, überwacht werden. Die Homogenität der Temperaturverteilung kann so besonders hoch in Längs- und Querrichtung aufgelöst werden.

Gemäß einem weiteren Aspekt der vorliegenden Erfindung ist die zweite elektrisch leitfähige Schicht und bzw. oder die dritte elektrisch leitfähige Schicht oberhalb, vorzugsweise direkt an der ersten elektrisch leitfähigen Schicht angrenzend angeordnet.

Mit anderen Worten kann die zweite elektrisch leitfähige Schicht oberhalb, vorzugsweise direkt an der ersten elektrisch leitfähigen Schicht angrenzend angeordnet sein. Zusätzlich kann die dritte elektrisch leitfähige Schicht oberhalb der zweiten elektrisch leitfähigen Schicht angeordnet sein.

Alternativ kann die erste elektrisch leitfähige Schicht zwischen der zweiten und der dritten elektrisch leitfähigen Schicht angeordnet sein, sodass die zweite und die dritte elektrisch leitfähige Schicht direkt an der ersten elektrisch leitfähigen Schicht angeordnet sein können. Ein zu großer Abstand zwischen der Referenzstruktur und der ersten elektrisch leitfähigen Schicht mit ggfs. dazwischen liegenden thermisch isolierenden Schichten kann zu Abweichungen der Alterung der Referenzstruktur von der ersten elektrisch leitfähigen Schicht führen. Durch den direkten Kontakt der zweiten elektrisch leitfähigen Schicht und der dritten elektrisch leitfähigen Schicht zu der ersten elektrisch leitfähigen Schicht und die unmittelbare thermische Einwirkung der ersten elektrisch leitfähigen Schicht kann eine besonders präzise Überwachung der Alterung und bzw. oder des Temperaturgradienten der ersten elektrisch leitfähigen Schicht ermöglicht werden.

Gemäß einem weiteren Aspekt der vorliegenden Erfindung ist ein Einzelsegment der zweiten elektrisch leitfähigen Schicht und bzw. oder der dritten elektrisch leitfähigen Schicht wenigstens einem, vorzugsweise einer Mehrzahl Einzelsegmente der ersten elektrisch leitfähigen Schicht zugeordnet bzw. steht mit den Einzelsegmenten in Kontakt.

Durch sich in Längs- und Querrichtung erstreckende Einzelsegmente der zweiten und bzw. oder dritten elektrisch leitfähigen Schicht kann die Homogenität der Temperaturverteilung in Längs- und Querrichtung überwacht werden. Hierzu können auch nur die Einzelsegmente einer einzigen elektrisch leitfähigen Schicht, z.B. der zweiten elektrisch leitfähigen Schicht, geeignet sein, sofern diese sich im Wesentlichen in unterschiedliche Längs- und Querrichtungen erstrecken.

Mit steigender Anzahl der Einzelsegmente der zweiten und bzw. oder dritten elektrisch leitfähigen Schicht kann die Auflösung der Widerstandsüberwachung gesteigert werden. Andererseits kann mit sinkender Anzahl der Einzelsegmente der zweiten und bzw. oder dritten elektrisch leitfähigen Schicht der Aufwand damit verbunden auch die Kosten der Herstellung geringgehalten werden. Je nach Anforderung kann durch die Variation der Anzahl der Einzelsegmente der zweiten und bzw. oder dritten elektrisch leitfähigen Schicht eine bestmögliche wirtschaftliche Lösung bei einer gleichzeitig anforderungsgerechten Messwertauflösung bereitgestellt werden.

Gemäß einem weiteren Aspekt der vorliegenden Erfindung ist innerhalb der elektronischen Rechenvorrichtung eine Kalibrierkurve hinterlegbar, durch welche einem elektrischen Widerstand der Einzelsegmente der zweiten elektrisch leitfähigen Schicht und bzw. oder der dritten elektrisch leitfähigen Schicht eine Temperatur zugeordnet werden kann.

Die jeweilige elektrisch leitfähige Schicht kann als PTC-Widerstand ausgebildet sein und somit einen mit steigender Temperatur steigenden Widerstand aufweisen, in einer vorteilhaften Ausführung einen mit steigender Temperatur proportional steigenden Widerstand. Über eine auf der elektronischen Rechenvorrichtung hinterlegte Kennlinie kann jedem Widerstandswert der Einzelsegmente der elektrisch leitfähigen Schichten eine Temperatur zugeordnet werden, sodass die jeweilige elektrisch leitfähige Schicht selbst einen Temperatursensor bilden kann.

Gemäß einem weiteren Aspekt der vorliegenden Erfindung entspricht der durch die elektronische Rechenvorrichtung bestimmte elektrische Widerstand dem Warmwiderstand nach Erreichen und Halten einer konstanten Soll-Temperatur. Eine solche Bedingung kann beispielsweise immer 60 Sekunden nach Erreichen einer definierten Temperatur vorliegen. Hierdurch können temperaturbedingte Einflüsse auf die Widerstandsmessung ausgeschlossen werden. Für eine eindeutige und präzise Bestimmung des Warmwiderstands ist demnach eine Überwachung der aktuellen Betriebsspannung, der Stromstärke sowie der Temperatur der ersten elektrisch leitfähigen Schicht erforderlich. Der elektrische Warmwiderstand kann so nach Erreichen und Halten einer definierten Temperatur, einer so genannten "Steady State" Bedingung, im Ursprungszustand ermittelt und gespeichert werden. Während des Betriebs kann der elektrische Warmwiderstand bei derselben Temperatur erneut gemessen und mit dem Warmwiderstand im Ursprungszustand verglichen werden.

Gemäß einem weiteren Aspekt der vorliegenden Erfindung weist das System eine Verbundstruktur, aufweisend eine Oberschicht, ein unterhalb der Oberschicht angeordnetes, vorzugsweise direkt an die Oberschicht angrenzendes Substrat und vorzugsweise eine Unterschicht auf.

Die Oberschicht bildet die sichtbare Vorderseite der Verbundstruktur und ist vorzugsweise aus einem polymeren Material, beispielsweise einem thermoplastischem Polyolefin oder aus einem Polyurethan ausgebildet. Die Oberschicht kann jedoch auch ein textiles Flächengebilde oder ein Echtleder aufweisen bzw. daraus ausgebildet sein. Durch die Oberschicht können der Oberfläche der Verbundstruktur angenehme optische und haptische Eigenschaften verliehen werden, deren Effekt sich durch eine Strukturierung, z. B. in Form einer Prägung der die Oberfläche der Verbundstruktur bildenden außenliegenden Seite der Oberschicht verstärken lässt.

Die Unterschicht kann der Verbundstruktur weiche Eigenschaften verleihen und aus einem Polymerschaum, beispielsweise aus einem Polyvinylchlorid-, Polyolefin- oder Polyurethanschaum ausgebildet sein. Der Polymerschaum kann ggfs. unter Verwendung eines Haftvermittlers auf das Substrat aufkaschiert werden.

Die vorliegende Anmeldung betrifft außerdem ein Fahrzeug mit einem erfindungsgemäßen System zur Überwachung einer elektrischen Widerstandsänderung mit einer auf dem Substrat angeordneten elektrisch leitfähigen Schicht. Die zuvor genannten Eigenschaften und Vorteile lassen sich auf ein Fahrzeug übertragen, dessen Oberflächen im Innenraum, beispielsweise im Bereich der Türverkleidung, der Armlehne oder der Instrumententafel elektrisch leitfähige Schichten aufweisen und dadurch z. B. beheizbar sind.

Die vorliegende Anmeldung betrifft außerdem ein Verfahren zur Überwachung einer elektrischen Widerstandsänderung mit einer auf einem Substrat angeordneten ersten elektrisch leitfähigen Schicht und einer zweiten elektrisch leitfähigen Schicht und vorzugsweise einer dritten elektrisch leitfähigen Schicht, mit Hilfe eines erfindungsgemäßen Systems. Das erfindungsgemäße Verfahren ist gekennzeichnet durch die folgenden Verfahrensschritte:
a) Bestimmung eines elektrischen Widerstands im Ursprungszustand jedes Einzelsegments der zweiten elektrisch leitfähige Schicht und vorzugsweise der dritten elektrisch leitfähigen Schicht, durch die elektronische Rechenvorrichtung und Hinterlegen des jeweiligen elektrischen Widerstands im Ursprungszustand in der elektronischen Rechenvorrichtung,
b) Bestimmung des aktuellen elektrischen Widerstands jedes Einzelsegments der zweiten elektrisch leitfähigen Schicht und vorzugsweise der dritten elektrisch leitfähigen Schicht,
c) Überprüfung der Abweichung des aktuellen elektrischen Widerstands jedes Einzelsegments der zweiten elektrisch leitfähigen Schicht und vorzugsweise der dritten elektrisch leitfähigen Schicht, gegenüber dem elektrischen Widerstand jedes Einzelsegments der zweiten elektrisch leitfähigen Schicht und vorzugsweise der dritten elektrisch leitfähigen Schicht im Ursprungszustand auf Einhaltung definierter und in der elektronischen Rechenvorrichtung hinterlegter Grenzwerte,
d) Überprüfung der Abweichung des aktuellen elektrischen Widerstands jedes Einzelsegments der zweiten elektrisch leitfähigen Schicht und vorzugsweise der dritten elektrisch leitfähigen Schicht untereinander auf Einhaltung definierter und in der elektronischen Rechenvorrichtung hinterlegter Grenzwerte.

Vorzugsweise ist der Widerstand der Warmwiderstand nach Erreichen und Halten einer konstanten Soll-Temperatur.

Auf besonders vorteilhafte Weise kann durch das erfindungsgemäße Verfahren eine Überwachung der Änderung der elektrischen Widerstände der zweiten und vorzugsweise dritten elektrisch leitfähigen Schicht gegenüber dem Ursprungszustand bereitgestellt werden. Durch einen direkten Zusammenhang der Alterung der zweiten bzw. dritten elektrisch leitfähigen Schicht zu der Alterung der ersten elektrisch leitfähigen Schicht, kann auf eine technisch sehr aufwändige Widerstandsmessung der Einzelsegmente der ersten elektrisch leitfähigen Schicht verzichtet werden. Die erste elektrisch leitfähige Schicht und die zweite bzw. dritte elektrisch leitfähige Schicht erfahren z. B. bei wiederkehrendem Wärmeeintrag parallele und proportionale Alterungseffekte. Die zweite bzw. dritte elektrisch leitfähige Schicht bildet mit anderen Worten eine Referenzstruktur zur indirekten Überwachung der Alterung der ersten elektrisch leitfähigen Schicht.

Durch den Abgleich der aktuellen elektrischen Widerstandswerte der Einzelsegmente der zweiten bzw. dritten elektrisch leitfähigen Schicht untereinander kann darüber hinaus unabhängig von Alterungseffekten Rückschluss auf eine inhomogene Verteilung der elektrischen Widerstände der Einzelsegmente gezogen werden. Hierdurch kann bei Stromführung der ersten elektrisch leitfähigen Schicht und einer sich einstellenden und in einer Wärmeabgabe resultierenden widerstandsbedingten Verlustleitung auch Rückschluss auf eine inhomogene Temperaturverteilung über die Fläche des Substrats bzw. der ersten elektrisch leitfähigen Schicht gezogen werden.

Es wird ausdrücklich darauf hingewiesen, dass die vorstehend erläuterten Ausgestaltungen der Erfindung jeweils für sich oder in einer beliebigen technisch sinnvollen Kombination auch untereinander jeweils mit dem Gegenstand des Anspruchs 1 und bzw. oder dem unabhängigen Anspruch 10 kombinierbar sind.

Anhand der Figuren werden im Folgenden beispielhaft mehrere Ausführungsbeispiele der Erfindung schematisch dargestellt und näher erläutert.
Fig. 1 zeigt eine schematische Darstellung einer aus dem Stand der Technik bekannten Lösung eines Substrats mit einer elektrisch heizbaren Schicht gemäß eines ersten Ausführungsbeispiels.
Fig. 2 zeigt eine schematische Darstellung eines erfindungsgemäßen Systems gemäß eines zweiten Ausführungsbeispiels.
Fig. 3 zeigt das erfindungsgemäße System gemäß eines dritten Ausführungsbeispiels in einer Seitenansicht.
Fig. 4 zeigt eine schematische Darstellung eines erfindungsgemäßen Systems gemäß eines vierten Ausführungsbeispiels.
Fig. 5A zeigt eine schematische Darstellung eines erfindungsgemäßen Systems gemäß eines fünften Ausführungsbeispiels.
Fig. 5B zeigt das erfindungsgemäße System aus Fig. 5A in einer Seitenansicht.

Die Beschreibung der o.g. Figuren erfolgt in kartesischen Koordinaten mit einer Längsrichtung X, einer zur Längsrichtung X senkrecht ausgerichteten Querrichtung Y sowie einer sowohl zur Längsrichtung X als auch zur Querrichtung Y senkrecht ausgerichteten vertikalen Richtung Z. Die Längsrichtung X kann auch als Tiefe X, die Querrichtung Y auch als Breite Y und die vertikale Richtung Z auch als Höhe Z bezeichnet werden. Die Längsrichtung X und die Querrichtung Y bilden gemeinsam die Horizontale, X, Y, welche auch als horizontale Ebene X, Y bezeichnet werden kann. Die Längsrichtung X, die Querrichtung Y und die vertikale Richtung Z können gemeinsam auch als Raumrichtungen X, Y, Z bzw. als kartesische Raumrichtungen X, Y, Z bezeichnet werden.

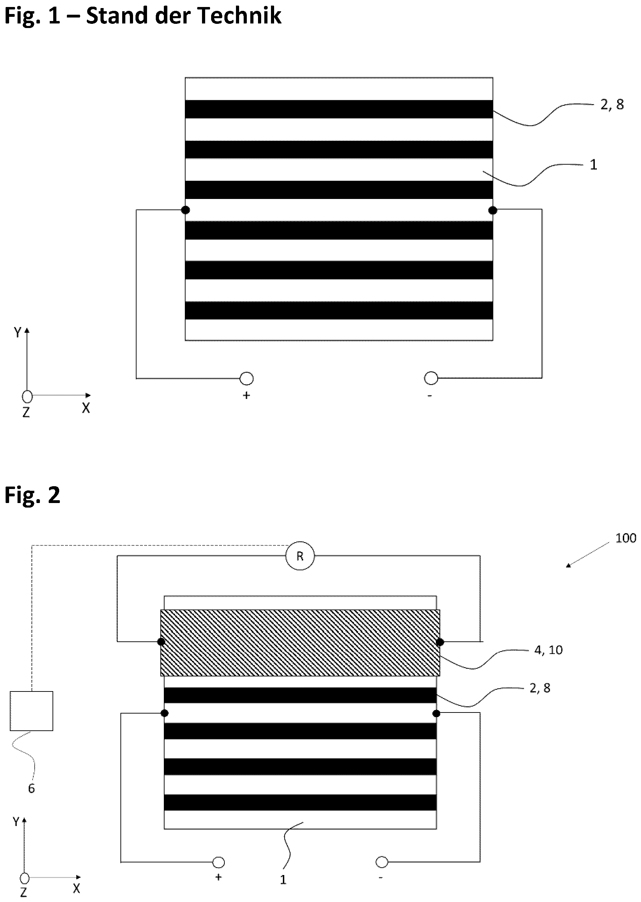

Figur 1 zeigt eine schematische Darstellung einer aus dem Stand der Technik bekannten Lösung eines mit einer ersten elektrisch leitfähigen Schicht 2 beschichteten Substrats 1. Die erste elektrisch leitfähige Schicht 2 weist mehrere zu einem elektrischen Zweipol parallel geschaltete, sich im Wesentlichen in Längsrichtung X erstreckende elektrisch leitfähige Einzelsegmente 8 auf. Die Einzelsegmente 8 sind in den dargestellten Ausführungsbeispielen miteinander über eine das Substrat 1 begrenzende Leiterbahn elektrisch leitfähig verbunden.

Die das Substrat 1 begrenzende Leiterbahn ist mit einer Spannungsquelle verbunden. Die elektrisch leitfähige Einzelsegmente 8 weisen einen elektrischen Widerstand auf. Bei Stromführung der elektrisch leitfähigen Einzelsegmente 8 entsteht hierdurch eine Verlustleistung, die in einer Erwärmung der elektrisch leitfähigen Einzelsegmente 8 der ersten elektrischen Leitfähigen Schicht 2 resultiert. Durch die dauerhafte Wärmebelastung kann die erste elektrisch leitfähige Schicht 2 insgesamt thermisch altern, was sich in einer Veränderung des elektrischen Widerstands sowie der Größe der Verlustleistung und der daraus resultierenden Wärmeabgabe äußert. Durch die teils individuellen und voneinander abweichenden Einzelwiderstände der elektrisch leitfähigen Einzelsegmente 8 kann die Verlustleistung und somit die Wärmeabgabe über die Fläche der ersten elektrischen Leitfähigen Schicht 2 inhomogen verteilt sein.

Eine beispielhafte Ausführungsform eines erfindungsgemäßen Systems 100 ist in der Figur 2 schematisch dargestellt. Hierbei ist auf dem Substrat 1 oberhalb der ersten elektrisch leitfähigen Schicht 2 eine zweite elektrisch leitfähige Schicht 4 angeordnet. Die zweite elektrisch leitfähige Schicht 4 ist aus demselben Material wie die erste elektrisch leitfähigen Schicht 2 ausgebildet, weshalb ein direkter Zusammenhang zu der Alterung der ersten elektrisch leitfähigen Schicht 2 hergestellt werden kann. Die Widerstandsänderung der somit als Referenzstruktur ausgebildeten zweiten elektrisch leitfähigen Schicht 4 ist somit repräsentativ für die Widerstandsänderung der ersten elektrisch leitfähigen Schicht 2. Die zweite elektrisch leitfähige Schicht 4 umfasst in dem dargestellten Beispiel ein elektrisch leitfähiges Einzelsegment 10. Das elektrisch leitfähige Einzelsegment 10 erstreckt sich im Wesentlichen in Längsrichtung X und steht mit zwei elektrisch leitfähigen Einzelsegmenten 8 in Kontakt. Das elektrisch leitfähige Einzelsegment 10 ist zur Widerstandsmessung mit einer elektronischen Rechenvorrichtung 6 verbunden. So kann durch das Einzelsegment 10 der zweiten elektrisch leitfähige Schicht eine inhomogene Verteilung der Widerstände der Einzelsegmente 8 der ersten elektrisch leitfähigen Schicht 2 bzw. eines daraus bestimmbaren Temperaturgradienten in Querrichtung Y überwacht werden.

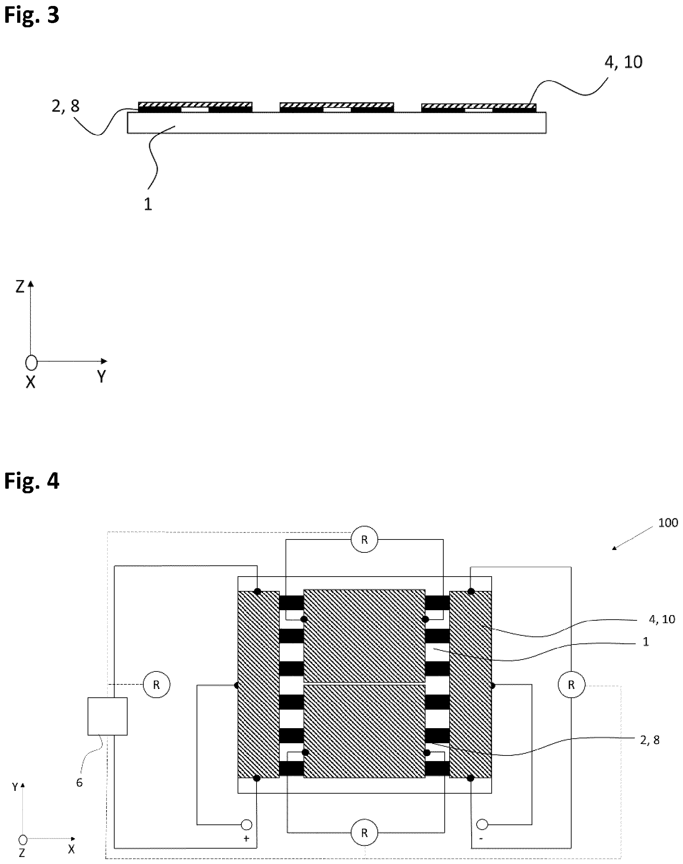

Figur 3 zeigt das erfindungsgemäße System 100 gemäß eines dritten Ausführungsbeispiels in einer Seitenansicht. Hierbei ist in vertikaler Richtung Z betrachtet auf dem Substrat 1 die erste elektrisch leitfähige Schicht 2 mit insgesamt sechs elektrisch leitfähigen Einzelsegmenten 8 angeordnet. Auf der ersten elektrisch leitfähigen Schicht 2 ist die zweite elektrisch leitfähige Schicht 4 mit insgesamt drei elektrisch leitfähigen Einzelsegmenten 10 angeordnet. Jeweils ein elektrisch leitfähiges Einzelsegment 10 steht mit zwei elektrisch leitfähigen Einzelsegmenten 8 in Kontakt.

Fig. 4 zeigt das erfindungsgemäßen System 100 gemäß eines vierten Ausführungsbeispiels. Hierbei umfasst die zweite elektrisch leitfähige Schicht 4 insgesamt vier elektrisch leitfähige Einzelsegmente 10. Zwei der elektrisch leitfähigen Einzelsegmente 10 sind im Randbereich des Substrats 1 angeordnet, erstrecken sich im Wesentlichen in Querrichtung Y und stehen mit jedem der sechs elektrisch leitfähigen Einzelsegmente 8 in Kontakt. Zwei weitere Einzelsegmente 10 erstrecken sich mittig des Substrats 1 sowohl in Längsrichtung X als auch in Querrichtung Y. Jedes der vier Einzelsegmente 10 ist zur Widerstandsmessung mit der elektronischen Rechenvorrichtung 6 verbunden. Über eine solche Anordnung der Referenzstrukturen kann eine Überwachung der Homogenität der Widerstands- bzw. Temperaturverteilung in der Horizontalen X, Y mit nur der zweiten elektrisch leitfähigen Schicht 4 erfolgen.

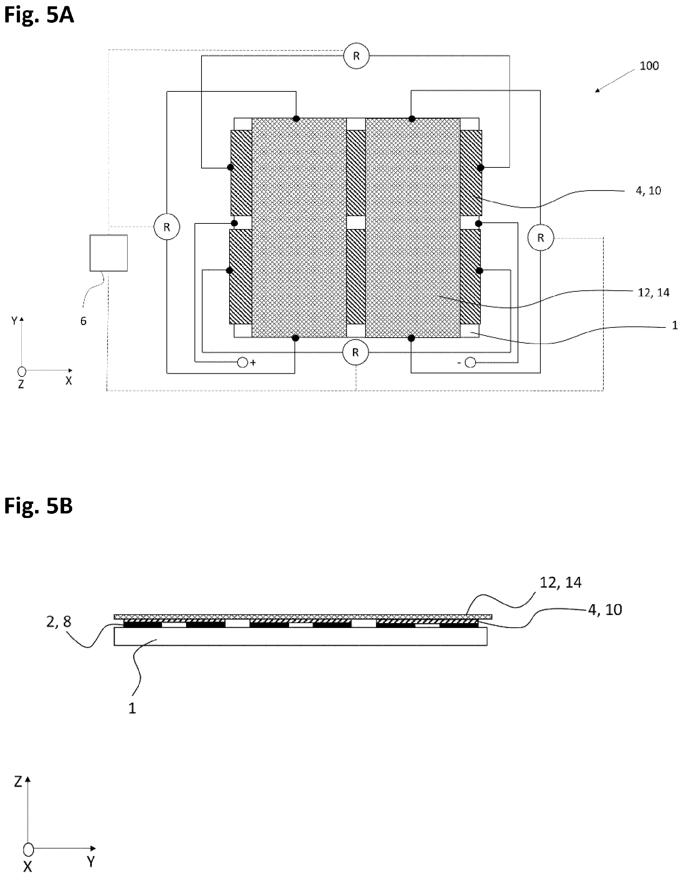

Fig. 5A zeigt eine schematische Darstellung des erfindungsgemäßen Systems 100 gemäß eines fünften Ausführungsbeispiels. Hierbei ist zusätzlich zu der zweiten elektrisch leitfähigen Schicht 4 mit den Einzelsegmenten 10 eine dritte elektrisch leitfähige Schicht 12 mit Einzelsegmenten 14 auf dem Substrat 1 angeordnet. Jedes der elektrisch leitfähigen Einzelsegmente 10, 14 ist mit der elektronischen Rechenvorrichtung 6 zur Widerstandsmessung verbunden. Die Einzelsegmente 14 erstrecken sich im Wesentlichen in Querrichtung Y und sind im Wesentlichen quer zu den in Längsrichtung X verlaufenden Einzelsegmenten 10 angeordnet. So kann durch die Einzelsegmente 10 eine inhomogene Verteilung der Widerstände bzw. eines daraus bestimmbaren Temperaturgradienten in Querrichtung Y und durch die Einzelsegmente 14 eine inhomogene Verteilung der Widerstände bzw. eines daraus bestimmbaren Temperaturgradienten in Längsrichtung X überwacht werden.

Figur 5B zeigt das erfindungsgemäße System 100 aus Figur 5A in einer Seitenansicht. Hierbei ist in vertikaler Richtung Z betrachtet auf dem Substrat 1 die erste elektrisch leitfähige Schicht 2 mit insgesamt sechs elektrisch leitfähigen Einzelsegmenten 8 angeordnet. Auf der ersten elektrisch leitfähigen Schicht 2 ist die zweite elektrisch leitfähige Schicht 4 mit insgesamt drei elektrisch leitfähigen Einzelsegmenten 10 angeordnet. Jeweils ein elektrisch leitfähiges Einzelsegment 10 steht mit zwei elektrisch leitfähigen Einzelsegmenten 8 in Kontakt. Oberhalb der zweiten elektrisch leitfähigen Schicht 4 ist die dritte elektrisch leitfähige Schicht 12 mit den Einzelsegmenten 14 angeordnet.

### Bezugszeichenliste (Teil der Beschreibung)

- 1.: Substrat
- 2.: erste elektrisch leitfähige Schicht
- 4.: zweite elektrisch leitfähige Schicht
- 6.: elektronische Rechenvorrichtung
- 8.: Einzelsegment der ersten elektrisch leitfähigen Schicht
- 10.: Einzelsegment der zweiten elektrisch leitfähigen Schicht, Referenzstruktur
- 12.: dritte elektrisch leitfähige Schicht
- 14.: Einzelsegment der dritten elektrisch leitfähigen Schicht, Referenzstruktur
- 100.: System

- Rₙₑᵤ: elektrischer Widerstand im Ursprungszustand
- Rₐₖₜᵤₑₗₗ: elektrischer Widerstand zum aktuellen Zeitpunkt

- X: Längsrichtung; Tiefe
- Y: Querrichtung; Breite
- Z: vertikale Richtung; Höhe
- X, Y: Horizontale; horizontale Ebene

## Patentansprüche

1. System (100) zur Überwachung einer elektrischen Widerstandsänderung mit einer auf einem Substrat (1) angeordneten ersten elektrisch leitfähigen Schicht (2) und einer zweiten elektrisch leitfähigen Schicht (4) und vorzugsweise einer dritten elektrisch leitfähigen Schicht (12), wobei die erste Schicht (2) und die zweite Schicht (4) und vorzugsweise die dritte Schicht (12) mehrere Einzelsegmente (8, 10, 14) aufweisen, wobei die Einzelsegmente (8) parallel geschaltet sind,
und wobei jedes Einzelsegment (10, 14) mit einer elektronischen Rechenvorrichtung (6) verbunden ist,
**dadurch gekennzeichnet, dass**
die elektronische Rechenvorrichtung (6) ausgebildet ist, einen elektrischen Widerstand (Rₙₑᵤ) jedes Einzelsegments (10, 14) im Ursprungszustand zu bestimmen und in der elektronischen Rechenvorrichtung (6) zu hinterlegen und die Einhaltung definierter und in der elektronischen Rechenvorrichtung (6) hinterlegter Grenzwerte anhand einer Abweichung eines aktuellen elektrischen Widerstands (Rₐₖₜᵤₑₗₗ) jedes Einzelsegments (10, 14) gegenüber dem elektrischen Widerstand (Rₙₑᵤ) jedes Einzelsegments (10, 14) im Ursprungszustand,
und anhand einer Abweichung des aktuellen elektrischen Widerstands (Rₐₖₜᵤₑₗₗ) jedes Einzelsegments (10, 14) untereinander zu überprüfen.

2. System (100) nach Anspruch 1,
**dadurch gekennzeichnet, dass**
die erste elektrisch leitfähige Schicht (2) elektrisch beheizbar ist.

3. System (100) nach Anspruch einem der vorhergehenden Ansprüche,
**dadurch gekennzeichnet, dass**
die Einzelsegmente (14) im Wesentlichen quer zu den Einzelsegmenten (10) verlaufend angeordnet sind.

4. System (100) nach einem der vorhergehenden Ansprüche,
**dadurch gekennzeichnet, dass**
die zweite elektrisch leitfähige Schicht (4) und/oder die dritte elektrisch leitfähige Schicht (12) oberhalb, vorzugsweise direkt an der ersten elektrisch leitfähigen Schicht (2) angrenzend angeordnet sind.

5. System (100) nach einem der vorhergehenden Ansprüche,
**dadurch gekennzeichnet, dass**
ein Einzelsegment (10, 14) wenigstens einem, vorzugsweise einer Mehrzahl Einzelsegmente (8) zugeordnet ist bzw. mit den Einzelsegmenten (8) in Kontakt steht.

6. System (100) nach einem der vorhergehenden Ansprüche,
**dadurch gekennzeichnet, dass**
innerhalb der elektronischen Rechenvorrichtung (6) eine Kalibrierkurve hinterlegbar ist, durch welche einem elektrischen Widerstand (Rₐₖₜᵤₑₗₗ, Rₙₑᵤ) der Einzelsegmente (10, 14) eine Temperatur zugeordnet werden kann.

7. System (100) nach einem der vorhergehenden Ansprüche,
**dadurch gekennzeichnet, dass**
der durch die elektronische Rechenvorrichtung (6) bestimmte elektrische Widerstand (Rₐₖₜᵤₑₗₗ, Rₙₑᵤ) dem Warmwiderstand nach Erreichen und Halten einer konstanten Soll-Temperatur entspricht.

8. System (100) nach einem der vorhergehenden Ansprüche, mit einer Verbundstruktur, aufweisend eine Oberschicht, ein unterhalb der Oberschicht angeordnetes, vorzugsweise direkt an die Oberschicht angrenzendes Substrat (1) und vorzugsweise eine Unterschicht.

9. Fahrzeug mit einem System (100) zur Überwachung einer elektrischen Widerstandsänderung mit einer auf dem Substrat (1) angeordneten elektrisch leitfähigen Schicht (2, 4, 12) nach einem der vorhergehenden Ansprüche.

10. Verfahren zur Überwachung einer elektrischen Widerstandsänderung mit einer auf einem Substrat (1) angeordneten ersten elektrisch leitfähigen Schicht (2) und einer zweiten elektrisch leitfähigen Schicht (4) und vorzugsweise einer dritten elektrisch leitfähigen Schicht (12), mit Hilfe eines Systems (100) nach einem der Ansprüche 1 bis 8, **gekennzeichnet durch** die folgenden Verfahrensschritte:
a) Bestimmung eines elektrischen Widerstands, vorzugsweise des Warmwiderstands, im Ursprungszustand (Rₙₑᵤ) jedes Einzelsegments (10, 14), durch die elektronische Rechenvorrichtung (6) und Hinterlegen des jeweiligen elektrischen Widerstands im Ursprungszustand (Rₙₑᵤ) in der elektronischen Rechenvorrichtung (6),
b) Bestimmung des aktuellen elektrischen Widerstands (Rₐₖₜᵤₑₗₗ), vorzugsweise des Warmwiderstands, jedes Einzelsegments (10, 14),
c) Überprüfung der Abweichung des aktuellen elektrischen Widerstands (Rₐₖₜᵤₑₗₗ) jedes Einzelsegments (10, 14), gegenüber dem elektrischen Widerstand jedes Einzelsegments (10, 14) im Ursprungszustand (Rₙₑᵤ) auf Einhaltung definierter und in der elektronischen Rechenvorrichtung (6) hinterlegter Grenzwerte,
d) Überprüfung der Abweichung des aktuellen elektrischen Widerstands (Rₐₖₜᵤₑₗₗ) jedes Einzelsegments (10, 14) untereinander auf Einhaltung definierter und in der elektronischen Rechenvorrichtung (6) hinterlegter Grenzwerte.
